# EUROPÄISCHE PATENTSCHRIFT

(11) **EP 2 714 472 B1**
(45) Veröffentlichungstag und Bekanntmachung des Hinweises auf die Patenterteilung: **12.08.2015**
(21) Anmeldenummer: 12714641.3
(22) Anmeldetag: 04.04.2012
(51) Int. Cl.: B60R 16/023, H05K 5/00, B60J 1/18, B60J 10/02, B60S 1/04, B60S 1/58, H05B 3/84, H05K 5/02

(54) **HECKSCHEIBE MIT ELEKTRIKSCHUTZBOX**
REAR WINDSHIELD COMPRISING ELECTRICS PROTECTION BOX
LUNETTE ARRIÈRE À BOÎTIER DE PROTECTION ÉLECTRIQUE

(30) Priorität: 23.05.2011 EP 11167015
(43) Veröffentlichungstag der Anmeldung: 09.04.2014
(73) Patentinhaber: Saint-Gobain Glass France, 92400 Courbevoie (FR)
(72) Erfinder: TIMMERMANN, Alwin, 50933 Köln (DE); DICKERS, Heinz-Erich, 50259 Pulheim (DE)
(74) Vertreter: Gebauer, Dieter Edmund
(86) Internationale Anmeldenummer: PCT/EP2012/056153
(87) Internationale Veröffentlichungsnummer: WO 2012/159813

(56) Entgegenhaltungen:
- EP-A1- 0 652 142
- DE-A1- 4 237 870
- DE-A1-102009 013 794
- DE-A1-102009 043 100
- GB-A- 2 167 120

## Beschreibung

Die Erfindung betrifft eine Heckscheibe mit Schutzbox, ein Verfahren zur Herstellung und deren Verwendung.

Heckscheiben werden in modernen Kraftfahrzeugen mit einer Vielzahl von technischen Funktionen ausgestattet. Beispiele hierfür sind Heckscheibenheizungen, integrierte Antennen oder Wischervorrichtungen. Neben den klassischen Heizwiderständen kommen somit in zunehmendem Maße auch Antennen- und Steuerungselektrik hinzu. Bei allen Anwendungsmöglichkeiten spielen zusätzlich zu den Schalt- und Steuerungsprozessoren die eigentlichen Verkabelungen eine zunehmend wichtigere Rolle. Diese Verkabelungen erfordern eine große Anzahl von Steckverbindungen oder elektronische Komponenten wie Antennenverstärker, welche platzsparend, feuchtigkeitsdicht und stabil angebracht werden müssen.

Aufgrund der zunehmenden komplexeren Vernetzung der elektrischen Komponenten nimmt gleichzeitig in vielen Fällen auch die Störanfälligkeit weiter zu. Während die eigentlichen Kabel relativ einfach gegenüber Umwelteinflüssen abgeschirmt werden können, gestaltet sich dies im Bereich der Steckverbindungen sehr viel schwieriger. Bei vielen Fahrzeugen ist zudem die eigentliche Steuerelektrik im sogenannten Nassraum der Karosserie untergebracht. Vor allem beim Übergang vom trockenen Innenbereich (Trockenraum) des Fahrzeugs in den Nassraum muss die Elektrik feuchtigkeitsdicht gestaltet sein. Feuchtigkeit kann im Bereich der Kabelverbindungen leicht zu Störungen wie Kurzschlüssen oder sogar zum kompletten Systemausfall führen. Um dies zu verhindern; werden Kabelverbindungen häufig mit Umschäumungen, beispielsweise Polyurethan versehen. Bei umschäumten Scheiben bietet es sich an, die zu schützenden Komponenten entweder direkt im Schaummaterial einzubetten, oder im Schäumprozess ohne zusätzlichen Arbeitsschritt die Wandungen eines Schutzgehäuses herzustellen. Das Schutzgehäuse wird in diesem Fall durch einen Deckel komplettiert und ermöglicht so einen dichten, für die spätere Montage von Elektronik-Komponenten oder für Wartungszwecke zugänglichen Bauraum.

Der Nachteil der Herstellung eines Schutzgehäuses aus dem Schaum-Material ist, dass aufgrund der Erfordernisse der Scheiben-Umschäumung das verwendete Material relativ weich eingestellt sein muss und damit große Wandstärken der im gleichen Prozess wie die Umschäumung hergestellten Strukturen des Schutzgehäuses erforderlich werden. Eine große Wandstärke bedeutet jedoch, dass die Dichtfläche zum Deckel vergleichsweise breit ist. Da die Kräfte auf den Deckel nicht beliebig hoch werden dürfen, ergibt sich infolgedessen eine niedrige Flächenpressung zwischen der Wand und dem Deckel des Schutzgehäuses. Damit wird eine sichere Abdichtung erschwert.

Eine weitere Problematik ergibt sich durch die Blasenbildung im Material der Umschäumung. Prozessseitig ist es nicht zu vermeiden, dass sich an den Dichtflächen im Schaummaterial im oberflächennahen Bereich Blasen bilden. Diese Blasen müssen in aufwändiger Nacharbeit geöffnet und mit neuem Umschäumungsmaterial ausgefüllt werden. Besonders problematisch ist die Blasenbildung im Bereich der Kabeldurchführungen durch die dickwandigen Seiten des Schutzgehäuses. Die komplexen Dichtflächen der Kabeldurchführungen sind für eine Nacharbeit kaum zugänglich.

Das Umschäumungsmaterial erlaubt es zudem nicht, stabile Halterungen für die elektronischen Komponenten innerhalb des Schutzgehäuses auszuformen. Eine definierte Fixierung der Komponenten innerhalb des Schutzgehäuses ist nur mit Hilfe von zusätzlichen Befestigungskomponenten möglich. Diese müssen in separaten und zusätzlichen Arbeitsschritten im Bereich des Schutzgehäuses angebracht werden.

DE 10 2009 013 794 A1 offenbart eine elektrische Verteilerbox in einem Kraftfahrzeug. Die Verteilerbox ist in der Lage, auch im Falle eines Verkehrsunfalls die Stromversorgung der einzelnen Verbraucher im Fahrzeug aufrecht zu erhalten.

GB 2,167,120 A offenbart eine ferngesteuerte Vorrichtung zum Öffnen und Schließen einer Heckscheibe in einem Fahrzeug.

EP 0 652 142 A1 offenbart eine Anordnung eines Heckteils eines Kraftfahrzeugs.

Die Aufgabe der Erfindung liegt darin, eine Vorrichtung bereitzustellen, welche Steuerungselektrik oder Kabelsteckverbindung im Bereich einer Fahrzeugheckscheibe stabil und wasserdicht abdichtet.

Die Aufgabe der vorliegenden Erfindung wird erfindungsgemäß durch eine Heckscheibe mit Schutzbox gemäß dem unabhängigen Anspruch 1 gelöst. Bevorzugte Ausführungen gehen aus den Unteransprüchen hervor.

Ein erfindungsgemäßes Verfahren zur Herstellung einer Heckscheibe mit Schutzbox und deren Verwendung gehen aus weiteren unabhängigen Ansprüchen hervor.

Die erfindungsgemäße Heckscheibe mit Schutzbox für elektronische Komponenten umfasst eine an einer Scheibe befestigte Karosserieanbindung. Die Karosserieanbindung fungiert als Anbindung oder Verbindungsteil zwischen der Heckscheibe und der Fahrzeugkarosserie. Die Karosserieanbindung umfasst bevorzugt Metalle und/oder Polymere, besonders bevorzugt Aluminium, Eisen, Titan, Chrom, Vanadium, Wolfram, Nickel oder Polyethylen, Polypropylen, Polystyrol, Polyurethane, Polymethylmetacrylate, Polyacrylate, Polyester, Polyamide, Polyethylenterephthalat und/oder Gemische oder Copolymere davon. Auf der Karosserieanbindung ist eine Schutzbox befestigt. Die Schutzbox umfasst einen Schutzbox-Grundkörper und einen Schutzbox-Deckel. Die Schutzbox umfasst bevorzugt Kunststoffe, bevorzugt Polymere, besonders bevorzugt Polyethylen, Polycarbonate, Polypropylen, Polystyrol, Polyurethane, Polymethylmetacrylate, Polyacrylate, Polyester, Polyamide, Polyethylenterephthalat. Eine Umschäumung umhüllt die Verbindungsplatte oder Karosserieanbindung sowie bevorzugt die Kontaktfläche der Scheibe mit der Karosserieanbindung. Die Umschäumung dichtet den Rand des Schutzbox-Grundkörpers an der Karosserieanbindung ab und fixiert den Schutzbox-Grundkörper auf der Karosserieanbindung.

Die Umschäumung dichtet bevorzugt den Schutzbox-Grundkörper über einen Flansch an der Karosserieanbindung ab und fixiert somit den Schutzbox-Grundkörper auf der Karosserieanbindung. Der Flansch ist ein Teil des Schutzbox-Grundkörpers und steht bevorzugt mindestens 3 mm seitlich von dem Schutzbox-Grundkörper und/oder mindestens 1mm vertikal von der Karosserieanbindung ab. Der Flansch befindet sich an der der Karosserieanbindung zugewandten Seite des Schutzbox-Grundkörpers.

Der Schutzbox-Grundkörper und/oder Flansch wird bevorzugt über ein doppelseitiges Klebeband oder ein Schaumband abdichtend an der Karosserieanbindung befestigt oder vorfixiert.

Die Schutzbox enthält bevorzugt ein Elektronik-Modul. Das Elektronik-Modul umfasst besonders bevorzugt eine Antennensteuerung, Heizungssteuerung, Schliesssteuerung und/oder Wischersteuerung.

Die Schutzbox enthält bevorzugt mindestens eine Halterung für einen oder mehrere Stecker oder Verbindungsstecker und Koppelungsstücke.

Die Schutzbox enthält bevorzugt Halterungen sowie Ausrichtungen für das Elektronik-Modul. Die Halterungen umfassen bevorzugt Verrastungen, Schraubverschlüsse oder Clipse, die Ausrichtungen umfassen bevorzugt Stützrippen zur reproduzierbaren Positionierung der Schutzbox.

Die Schutzbox weist bevorzugt eine Kabeldurchführung, besonders bevorzugt eine wasserdichte Kabeldurchführung auf.

Die Schutzbox enthält bevorzugt ein Trockenmittel, besonders bevorzugt Kieselgel, CaCl₂, Na₂SO₄, Aktivkohle, Silikate, Bentonite, Zeolithe und/oder Gemische davon. Die Trockenmittel können in die Oberfläche der Schutzbox eingearbeitet sein und/oder in offenen Behältnissen in der Schutzbox angeordnet sein. Die Trockenmittel sind bevorzugt so angeordnet, dass ein Luft- und Feuchtigkeitsaustausch mit der Luft im Inneren der Schutzbox möglich ist, die Materialien aber nicht umherfliegen können und fixiert sind. Dies kann bevorzugt durch Einschließen der Trockenmittel in einen luft- und feuchtigkeitsdurchlässigen Polymerfilm oder in einem feinmaschigen Netz erfolgen.

Der Schutzbox-Grundkörper und/oder der Schutzbox-Deckel weisen bevorzugt Clipse oder Schraubverschlüsse auf.

Die Umschäumung enthält bevorzugt Polyurethan, Isocyanate, Polyalkohole, Polystyrol, Polypropylen, Polyethylen, Polyethylenterephthalat, und/oder Gemische oder Copolymere davon.

Zwischen dem Schutzbox-Grundkörper und der Karosserieanbindung sind bevorzugt ein Dämpfungskörper, besonders bevorzugt ein Schaumstoff, Stoff oder Flies angeordnet. Der Dämpfungskörper vermindert die beim Fahren des Fahrzeugs auf die Schutzbox einwirkenden Vibrationen, Geräusche und Stöße.

Der Flansch am Schutzbox-Grundkörper weist bevorzugt Positionierhilfen, besonders bevorzugt Löcher, Langlöcher oder Nocken auf.

Die Erfindung umfasst des Weiteren ein Verfahren zur Herstellung einer Heckscheibe. In einem ersten Schritt wird ein Schutzbox-Grundkörper mit einem Flansch auf einer Karosserieanbindung befestigt. Die Befestigung kann beispielsweise mit Hilfe einer Verklebung und/oder einer Verschraubung erfolgen. Anschließend wird eine Scheibe, bevorzugt Heckscheibe, an der Karosserieanbindung befestigt. Eine Kontaktfläche der Scheibe mit der Karosserieanbindung sowie die Karosserieanbindung selbst werden mit einer Umschäumung versehen. Das Umschäumen erfolgt bevorzugt in der dem Fachmann geläufigen Weise in einer geeigneten Gießform. Die Umschäumung erfolgt flächig, sodass die Umschäumung den Schutzbox-Grundkörper über den Flansch an der Karosserieanbindung abdichtet und fixiert.

Der Schutzbox-Grundkörper wird bevorzugt in einem abschließenden Schritt mit einem Schutzbox-Deckel versehen und verschlossen. Der Verschluss kann sowohl reversibel als auch irreversibel ausgelegt sein.

Die Erfindung umfasst des Weiteren die Verwendung der Heckscheibe in Kraftfahrzeugen, Bussen und/oder Lastkraftwagen.

Im Folgenden wird die Erfindung anhand von einer Zeichnung näher erläutert. Die Zeichnung ist eine rein schematische Darstellung und nicht maßstabsgetreu. Sie schränkt die Erfindung in keiner Weise ein.

Es zeigen:
Figur 1 eine schematische Ansicht der erfindungsgemäßen Heckscheibe,
Figur 2 eine schematische Ansicht des auf der Karosserieanbindung befestigten Schutzbox-Grundkörpers,
Figur 3 einen Querschnitt der erfindungsgemäßen Heckscheibe,
Figur 4 eine schematische Ansicht der auf der Karosserieanbindung befestigten Schutzbox,
Figur 5 eine schematische Draufsicht einer bevorzugten Ausführungsform des auf der Karosserieanbindung befestigten Schutzbox-Grundkörpers und
Figur 6 ein Fließschema des erfindungsgemäßen Verfahrens.

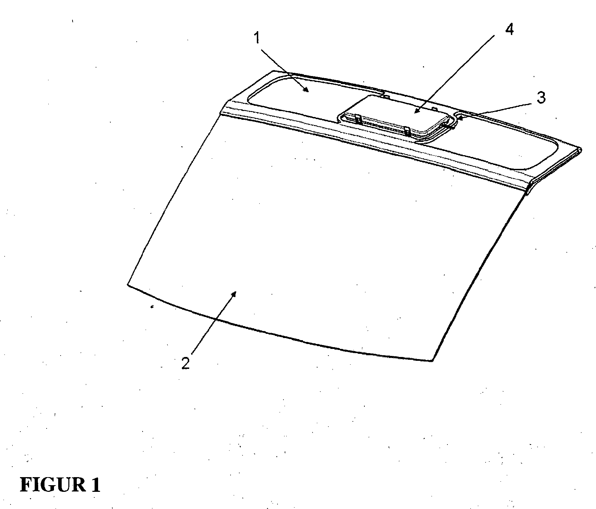

Figur 1 zeigt eine schematische Ansicht der erfindungsgemäßen Heckscheibe. Eine Scheibe (2) ist mit einer Karosserieanbindung (1) verbunden. Auf der Karosserieanbindung (1) ist eine Schutzbox (4) befestigt. Die Schutzbox (4) umfasst (nicht gezeigt) einen Schutzbox-Grundkörper (4a) und einen Schutzbox-Deckel (4b). Eine Umschäumung (3) umgibt die Karosserieanbindung (1) und die Kontaktfläche (5) zwischen der Scheibe (2) und der Karosserieanbindung (1). Die Umschäumung (3) fixiert die Schutzbox (4) an der Karosserieanbindung (1) und dichtet die Schutzbox (4) gleichzeitig ab.

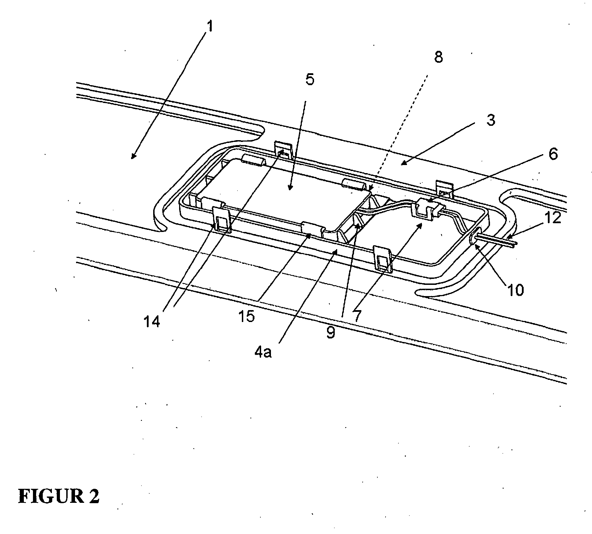

Figur 2 zeigt eine schematische Ansicht des auf der Karosserieanbindung (1) befestigten Schutzbox-Grundkörpers (4a). Die Umschäumung (3) fixiert den Schutzbox-Grundkörper (4a) an der Karosserieanbindung (1). Ausrichtung/Stützrippen (9) stabilisieren und richten den Schutzbox-Grundkörper (4a) aus. Der Schutzbox-Grundkörper (4a) enthält ein Elektronik-Modul (5), beispielsweise eine Antennensteuerung. Das Elektronik-Modul (5) ist über einen Stecker (6), welcher über eine Halterung (7) fixiert ist, mit einem nach außen führenden Kabel (12) verbunden. Eine abgedichtete Kabeldurchführung (10) verhindert das Eindringen von Feuchtigkeit in den Schutzbox-Grundkörper (4a). Der Schutzbox-Grundkörper (4a) wird über Clipse (14) mit dem nicht gezeigten Schutzbox-Deckel (4b) verschlossen und bildet die eigentliche Schutzbox (4). Unter dem Schutzbox-Grundkörper (4a) befinden sich bevorzugt Dämpfungskörper (8), welche die auf die Schutzbox (4) übertragenen Vibrationen vermindern.

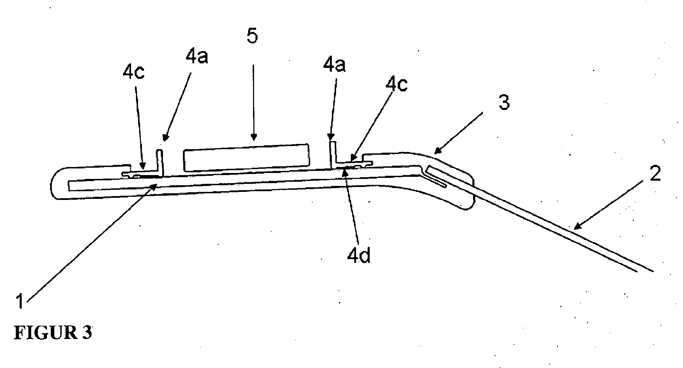

Figur 3 zeigt einen Querschnitt der erfindungsgemäßen Heckscheibe. Die Karosserieanbindung (1) ist mit einer Scheibe (2) verbunden. Eine Umschäumung (3) umschließt die Karosserieanbindung (1), einen Schutzbox-Grundkörper (4a) und eine Kontaktfläche (5) der Scheibe (2) mit der Karosserieanbindung (1). Die Umschäumung (3) versiegelt den Schutzbox-Grundkörper (4a) über einen Flansch (4c) an der Karosserieanbindung (1). Der Schutzbox-Grundkörper (4a) ist über ein doppelseitiges Klebeband (4d) an der Karosserieanbindung (1) befestigt. Innerhalb des Schutzbox-Grundkörpers (4a) ist ein Elektronik-Modul (5) angeordnet.

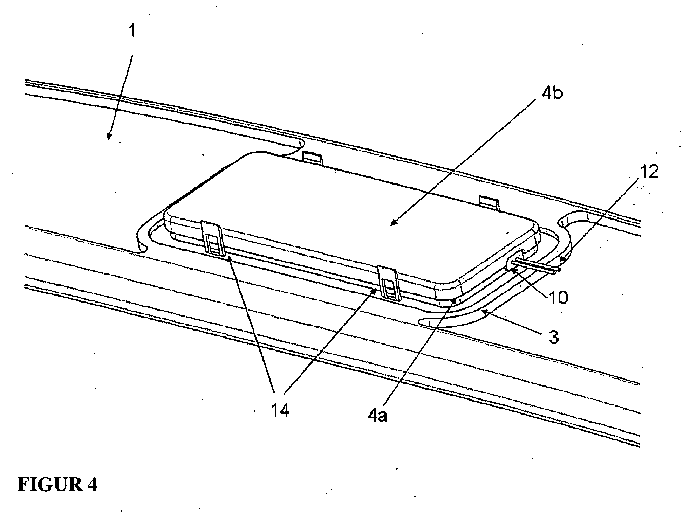

Figur 4 zeigt eine schematische Ansicht der auf der Karosserieanbindung (1) befestigten Schutzbox (4) aus dem Schutzbox-Grundkörper (4a) und dem Schutzbox-Deckel (4b). Clipse (14) ermöglichen einen wiederverschließbaren Verschluss der Schutzbox (4). Die elektrische Kontaktierung erfolgt über ein Kabel (12) durch eine wasserdichte Kabeldurchführung (10). Eine Umschäumung (3) umgibt die Schutzbox (4) auf der Karosserieanbindung (1).

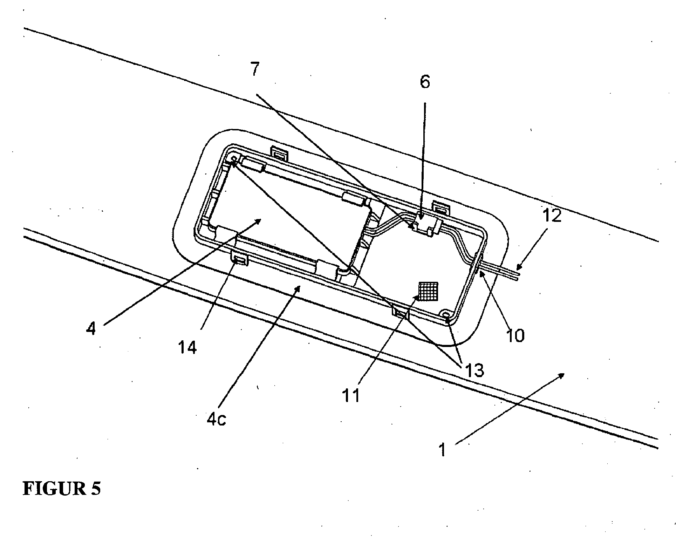

Figur 5 zeigt eine Draufsicht einer bevorzugten Ausführungsform des auf der Karosserieanbindung (1) befestigten Schutzbox-Grundkörpers (4a) und einen Flansch (4c). Der Aufbau aus Elektronik-Modul (5), Stecker (6), Halterung (7), nach außen führendem Kabel (12) und Kabeldurchführung (10) entspricht dem in Figur 2 gezeigten. Positionierhilfen (13) ermöglichen die Fixierung und Positionierung des Schutzbox-Grundkörpers vor der eigentlichen Befestigung oder Klebung. Ein Trockenmittel (11) fängt vorhandene Restfeuchtigkeit auf.

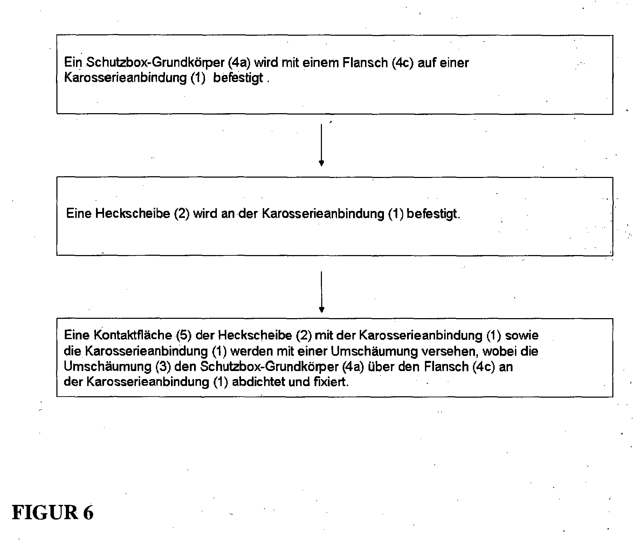

Figur 6 zeigt ein Fließschema des erfindungsgemäßen Verfahrens. In einem ersten Schritt wird ein Schutzbox-Grundkörper (4a) mit einem Flansch (4c) auf einer Karosserieanbindung (1) mit Hilfe einer Verklebung und/oder einer Verschraubung (13) befestigt. Anschließend wird eine Scheibe (2), bevorzugt Heckscheibe, an der Karosserieanbindung (1) befestigt. Alternativ kann das Befestigen der Scheibe auch am Anfang des Verfahrens direkt an der Karosserieanbindung (1) erfolgen. Eine Kontaktfläche (5) der Scheibe (2) mit der Karosserieanbindung (1) sowie die Karosserieanbindung (1) selbst werden mit einer Umschäumung (3) versehen. Das Umschäumen erfolgt bevorzugt in der dem Fachmann geläufigen Weise durch Spritzgießen in einer geeigneten Gießform. Die Umschäumung erfolgt zudem flächig, sodass die Umschäumung (3) den Schutzbox-Grundkörper (4) über den Flansch (4c) an der Karosserieanbindung (1) abdichtet und fixiert.

### Bezugszeichenliste

- (1): Karosserieanbindung
- (2): Scheibe
- (3): Umschäumung
- (4): Schutzbox
- (4a): Schutzbox-Grundkörper
- (4b): Schutzbox-Deckel
- (4c): Flansch
- (4d): doppelseitiges Klebeband/abdichtendes Schaumband
- (5): Elektronik-Modul
- (6): Stecker
- (7): Halterung
- (8): Dämpfungskörper
- (9): Ausrichtung/Stützrippen
- (10): Kabeldurchführung
- (11): Trockenmittel
- (12): Kabel
- (13): Positionierhilfe
- (14): Clipse/Schraubverschluss
- (15): Halterung/Verrastung

## Patentansprüche

1. Heckscheibe mit Schutzbox für elektronische Komponenten, umfassend:
a. eine an einer Scheibe (2) befestigte Karosserieanbindung (1),
b. eine auf der Karosserieanbindung (1) befestigte Schutzbox (4), umfassend einen Schutzbox-Grundkörper (4a) und einen Schutzbox-Deckel (4b),
c. eine Umschäumung (3) der Karosserieanbindung (1), wobei die Umschäumung (3) den Schutzbox-Grundkörper (4a) an der Karosserieanbindung (1) abdichtet und fixiert.

2. Heckscheibe nach Anspruch 1, wobei die Umschäumung (3) den Schutzbox-Grundkörper (4a) über einen Flansch (4c) an der Karosserieanbindung (1) abdichtet und fixiert.

3. Heckscheibe nach Anspruch 1 oder 2, wobei der Schutzbox-Grundkörper (4a) und/oder Flansch (4c) über einen Klebstoff oder doppelseitiges Klebeband (4d) an der Karosserieanbindung (1) befestigt ist.

4. Heckscheibe nach einem der Ansprüche 1 bis 3, wobei die Schutzbox (4) ein Elektronik-Modul (5), bevorzugt eine Antennensteuerung, Heizungssteuerung, Schliesssteuerung und/oder Wischersteuerung enthält.

5. Heckscheibe nach einem der Ansprüche 1 bis 4, wobei die Schutzbox (4) eine Halterung (7) für einen Stecker (6) enthält.

6. Heckscheibe nach einem der Ansprüche 1 bis 5, wobei die Schutzbox (4) Halterungen (15) und/oder Ausrichtungen (9) für das Elektronik-Modul (5) enthält.

7. Heckscheibe nach einem der Ansprüche 1 bis 6, wobei die Schutzbox (4) eine Kabeldurchführung (10), bevorzugt eine wasserdichte Kabeldurchführung aufweist.

8. Heckscheibe nach einem der Ansprüche 1 bis 7, wobei die Schutzbox (4) ein Trockenmittel (11) enthält.

9. Heckscheibe nach einem der Ansprüche 1 bis 8, wobei der Schutzbox-Grundkörper (4a) und/oder der Schutzbox-Deckel (4b) Clipse (14) oder Schraubverschlüsse aufweisen.

10. Heckscheibe nach einem der Ansprüche 1 bis 9, wobei die Umschäumung (3) Polyurethan, Isocyanate, Polyalkohole, Polystyrol, Polypropylen, Polyethylen, Polyethylenterephthalat, und/oder Gemische oder Copolymere davon enthält.

11. Heckscheibe nach einem der Ansprüche 1 bis 10, wobei zwischen dem Schutzbox-Grundkörper (4a) und der Karosserieanbindung (1) ein Dämpfungskörper (8), bevorzugt ein Schaumstoff, Stoff oder Flies angeordnet ist.

12. Heckscheibe nach einem der Ansprüche 2 bis 11, wobei der Flansch (4c) Positionierhilfen (13), bevorzugt Löcher, Langlöcher oder Nocken aufweist.

13. Verfahren zur Herstellung einer Heckscheibe, wobei
a. ein Schutzbox-Grundkörper (4a) mit einem Flansch (4c) auf einer Karosserieanbindung (1) befestigt wird und eine Karosserieanbindung (1) erhalten wird,
b. eine Scheibe (2) an der Karosserieanbindung (1) befestigt wird und
c. eine Kontaktfläche (5) der Scheibe (2) mit der Karosserieanbindung (1) sowie die Karosserieanbindung (1) mit einer Umschäumung (3) versehen wird, wobei die Umschäumung (3) den Schutzbox-Grundkörper (4a) über den Flansch (4c) an der Karosserieanbindung (1) abdichtet und fixiert.

14. Verfahren nach Anspruch 13, wobei der Schutzbox-Grundkörper (4a) mit einem Schutzbox-Deckel (4b) versehen wird.

15. Verwendung der Heckscheibe nach den Ansprüchen 1 bis 12 in Kraftfahrzeugen, Bussen und/oder Lastkraftwagen.

## Claims

1. Rear windshield with protection box for electronic components, comprising:
a. a vehicle body connection (1) fastened on a window pane (2),
b. a protection box (4) fastened on the vehicle body connection (1) comprising a protection box basic element (4a) and a protection box cover (4b),
c. a foam encapsulation (3) of the vehicle body connection (1), wherein the foam encapsulation (3) seals and affixes the protection box basic element (4a) on the vehicle body connection (1).

2. Rear windshield according to claim 1, wherein the foam encapsulation (3) seals and affixes the protection box basic element (4a) on the vehicle body connection (1) via a flange (4c).

3. Rear windshield according to claim 1 or 2, wherein the protection box basic element (4a) and/or flange (4c) is fastened on the vehicle body connection (1) via an adhesive or double-sided adhesive tape(4d).

4. Rear windshield according to one of claims 1 through 3, wherein the protection box (4) contains an electronics module (5), preferably an antenna control, heating control, closing control, and/or wiper control.

5. Rear windshield according to one of claims 1 through 4, wherein the protection box (4) includes a socket (7) for a plug (6).

6. Rear windshield according to one of claims 1 through 5, wherein the protection box (4) includes retainers (15) and/or alignment means (9) for the electronics module (5).

7. Rear windshield according to one of claims 1 through 6, wherein the protection box (4) has a cable pass-through (10), preferably a watertight cable bushing.

8. Rear windshield according to one of claims 1 through 7, wherein the protection box (4) contains a desiccant (11).

9. Rear windshield according to one of claims 1 through 8, wherein the protection box basic element (4a) and/or the protection box cover (4b) has clips (14) or threaded caps.

10. Rear windshield according to one of claims 1 through 9, wherein the foam encapsulation (3) contains polyurethane, isocyanates, polyalcohols, polystyrene, polypropylene, polyethylene, polyethylene terephthalate, and/or mixtures or copolymers thereof.

11. Rear windshield according to one of claims 1 through 10, wherein a damping element (8), preferably a foam, woven fabric, or nonwoven fabric is arranged between the protection box basic element (4a) and the vehicle body connection (1).

12. Rear windshield according to one of claims 2 through 11, wherein the flange (4c) has positioning aids (13), preferably holes, slots, or cams.

13. Method for producing a rear windshield, wherein
a. a protection box basic element (4a) is fastened with a flange (4c) on a vehicle body connection (1) and a vehicle body connection (1) is obtained,
b. a window pane (2) is fastened on the vehicle body connection (1), and
c. a contact surface (5) of the window pane (2) with the vehicle body connection (1) as well as the vehicle body connection (9) is provided with a foam encapsulation (3), wherein the foam encapsulation (3) seals and affixes the protection box basic element (4a) via the flange (4c) on the vehicle body connection (1).

14. Method according to claim 13, wherein the protection box basic element (4a) is provided with a protection box cover (4b).

15. Use of the rear windshield according to claims 1 through 12 in automobiles, buses, and/or trucks.

## Revendications

1. Vitre arrière avec un boîtier de protection pour composants électroniques, comprenant:
a. un raccordement à la carrosserie (1) attaché sur une vitre (2),
b. un boîtier de protection (4) attaché au raccordement à la carrosserie (1), comprenant un corps de base du boîtier de protection (4 a) et un couvercle du boîtier de protection (4b),
c. un enrobage en mousse (3) du raccordement à la carrosserie (1), où l'enrobage en mousse (3) scelle et fixe le boîtier de protection (4a) sur le raccordement à la carrosserie (1).

2. Vitre arrière selon la revendication, où l'enrobage en mousse (3) scelle et fixe le boîtier de protection (4a) sur le raccordement à la carrosserie (1) par une bride.

3. Vitre arrière selon la revendication 1 ou 2, où le corps de base du boîtier de protection (4 a) et/ou la bride (4c) sont attachés avec de la colle ou un ruban adhésif double face (4d) au raccordement à la carrosserie (1).

4. Vitre arrière selon l'une des revendications 1 à 3, où le boîtier de protection (4) renferme un module électronique (5), de préférence une commande d'antenne, une commande de chauffage, une commande de fermeture une commande d'essuie-glace.

5. Vitre arrière selon l'une des revendications 1 à 4, où le boîtier de protection (4) comprend un support (7) pour une prise (6).

6. Vitre arrière selon l'une des revendications 1 à 5, où le boîtier de protection renferme (4) des supports (15) et/ou des dispositifs (9) pour le module électronique (5).

7. Vitre arrière selon l'une des revendications 1 à 6, où le boîtier de protection (4) présente un passe-câble (10), de préférence un passe-câble imperméable à l'eau.

8. Vitre arrière selon l'une des revendications 1 à 7, où le boîtier de protection (4) contient un déshydratant (11).

9. Vitre arrière selon l'une des revendications 1 à 8, où le boîtier de protection (4 a) et/ou le couvercle du boîtier de protection (4b) présente des clips (14) ou des fermetures à vis.

10. Vitre arrière selon l'une des revendications 1 à 9, où l'enrobage en mousse (3) contient du polyuréthane, des isocyanates, des polyalcools, du polystyrène, du polypropylène, du polyéthylène, du polyéthylène téréphtalate, ou des mélanges ou des copolymères de ceux-ci.

11. Vitre arrière selon l'une des revendications 1 à 10, où un corps d'amortissement (8), de préférence une mousse, un tissu ou une toison est arrangé entre le boîtier de protection (4a) et le raccordement à la carrosserie (1).

12. Vitre arrière selon l'une des revendications de 2 à 11, où la bride (4c) présente (13), des aides au positionnement, de préférence des trous, des trous oblongs ou des cames.

13. Procédure pour la production d'une vitre arrière où
a. un boîtier de protection (4a) est fixé avec une bride (4c) sur un raccordement à la carrosserie (1) et un raccordement à la carrosserie (1) est obtenu,
b. une vitre (2) est attachée sur le raccordement à la carrosserie (1), et
c. une surface de contact (5) de la vitre (2) avec le raccordement à la carrosserie (1) ainsi que le raccordement à la carrosserie sont enrobés de mousse, où l'enrobage de mousse (3) scelle et fixe le corps de base du boîtier de protection (4a) par la bride (4c) sur le raccordement à la carrosserie (1).

14. Procédure selon la réclamation 13, dans lequel le boîtier de protection (4a) est fourni avec un couvercle de boîtier de protection (4b).

15. Utilisation de la vitre arrière selon les revendications 1 à 12 dans des véhicules automobiles, des autobus ou des camions.
